(19) Europäisches Patentamt
European Patent Office
Office européen des brevets

(11) **EP 3 561 530 B1**

(12) **EUROPEAN PATENT SPECIFICATION**

(45) Date of publication and mention
of the grant of the patent:
**06.04.2022 Bulletin 2022/14**

(21) Application number: **19167764.0**

(22) Date of filing: **08.04.2019**

(51) International Patent Classification (IPC):
**G01R 31/26** $^{(2020.01)}$

(52) Cooperative Patent Classification (CPC):
**G01R 31/2619; G01R 31/2628**

(54) **ABNORMALITY DETECTION DEVICE AND POWER SUPPLY DEVICE**

ANOMALIEERKENNUNGSVORRICHTUNG UND STROMVERSORGUNGSVORRICHTUNG

DISPOSITIF DE DÉTECTION D'ANOMALIES ET DISPOSITIF D'ALIMENTATION ÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.04.2018 JP 2018082778**

(43) Date of publication of application:
**30.10.2019 Bulletin 2019/44**

(73) Proprietor: **Yazaki Corporation
Minato-ku
Tokyo 108-8333 (JP)**

(72) Inventors:
• **OISHI, Eiichiro
Susono-shi, Shizuoka 410-1194 (JP)**
• **MORIMOTO, Mitsuaki
Susono-shi, Shizuoka 410-1194 (JP)**

(74) Representative: **Grünecker Patent- und
Rechtsanwälte
PartG mbB
Leopoldstraße 4
80802 München (DE)**

(56) References cited:
JP-A- 2014 222 802  JP-A- 2016 170 045
JP-A- 2016 184 506  JP-A- 2017 017 822
US-A- 5 721 455  US-A1- 2016 245 706

• SIEGAL B S ED - INSTITUTE OF ELECTRICAL AND ELECTRONICS ENGINEERS: "Thermal characterization of surface mount devices", PROCEEDINGS OF THE ANNUAL SEMICONDUCTOR THERMAL MEASUREMENT AND MANAGEMENT SYMPOSIUM. AUSTIN, FEB. 2 - 4, 19; [PROCEEDINGS OF THE ANNUAL SEMICONDUCTOR THERMAL MEASUREMENT AND MANAGEMENT SYMPOSIUM], NEW YORK, IEEE, US, vol. -, 2 February 1993 (1993-02-02), pages 99-107, XP010067683, DOI: 10.1109/STHERM.1993.225326 ISBN: 978-0-7803-0863-3
• BERNARD S SIEGEL: "Measuring thermal resistance is the key to a cool semiconductor", ELECTRONICS INT,, vol. 51, no. 14, 6 July 1978 (1978-07-06), pages 121-126, XP001327291,

**Description**

BACKGROUND OF THE INVENTION

1. Field of the Invention

The present invention relates to an abnormality detection device and a power supply device.

2. Description of the Related Art

Conventionally, for example, Japanese Patent Application Laid-open No. 2017-17822 discloses a semiconductor device. The semiconductor device is configured by including a substrate with a semiconductor device mounted on a mounting surface thereof and a metal base for heat dissipation provided on a side opposite to the mounting surface side of the substrate. The semiconductor device obtains the thermal resistance of a heat dissipation path between the semiconductor device and the metal base for heat dissipation based on a temperature difference between the semiconductor device before being driven and the semiconductor device after being driven. Based on the obtained thermal resistance, the semiconductor device detects an abnormality in the heat dissipation path for the semiconductor device caused by, for example, detachment of a joint portion between the semiconductor device and the substrate.

In the case of detecting the abnormality in the heat dissipation path for the semiconductor device, the semiconductor device described in Japanese Patent Application Laid-open No. 2017-17822 mentioned above detects the temperature of the semiconductor device before being driven, and thus needs to perform the additional processing for detecting the abnormality before driving the semiconductor device. This leaves room for further improvement.

Reference JP 2014 222802 (A) discloses a technique for keeping the power consumption of an amplifier within a predetermined range. To this end, a control section is provided, which calculates a heating value of the amplifier based on a difference between a temperature detected by a first temperature detection circuit and a temperature detected by a second temperature detection circuit and on a thermal resistance of a member between the first temperature detection circuit and the second temperature detection circuit. The control section calculates a power consumption of the amplifier on the basis of the heating value and an output power of the amplifier detected by an output power detection circuit. If the power consumption exceeds a predetermined range, a bias applied to the amplifier is adjusted accordingly.

SUMMARY OF THE INVENTION

Accordingly, the present invention has been made in view of the above-described circumstances, and an object thereof is to provide an abnormality detection device and a power supply device capable of appropriately detecting the abnormality in the heat dissipation path for the semiconductor device.

This is achieved by the features of the independent claim. Preferred embodiments are the subject matter of the dependent claims.

The above and other objects, features, advantages and technical and industrial significance of this invention will be better understood by reading the following detailed description of presently preferred embodiments of the invention, when considered in connection with the accompanying drawings.

BRIEF DESCRIPTION OF THE DRAWINGS

FIG. 1 is a block diagram illustrating a configuration example of a power supply device according to a first embodiment of the present invention;
FIG. 2 is a diagram illustrating a thermal network of a heat dissipation path of a semiconductor switch according to the first embodiment;
FIG. 3 is a flowchart illustrating an operation example of an abnormality detection device according to the first embodiment;
FIG. 4 is a block diagram illustrating a configuration example of a power supply device according to a second embodiment of the present invention;
FIG. 5 is a diagram illustrating temperature characteristics of a forward voltage of a diode according to the second embodiment;
FIG. 6 is a timing diagram illustrating a method for detecting the forward voltage of the diode according to the

second embodiment; and

FIG. 7 is another timing diagram illustrating the method for detecting the forward voltage of the diode according to the second embodiment.

DETAILED DESCRIPTION OF THE PREFERRED EMBODIMENTS

The following describes modes (embodiments) for carrying out the present invention in detail with reference to the drawings. The present invention is not limited to the description of the embodiments to be given below. Components described below include those easily conceivable by those skilled in the art or those substantially identical thereto. Moreover, configurations described below can be combined as appropriate. Furthermore, the configurations can be variously omitted, replaced, or modified within the scope of the present invention, which is defined by the claims.

First Embodiment

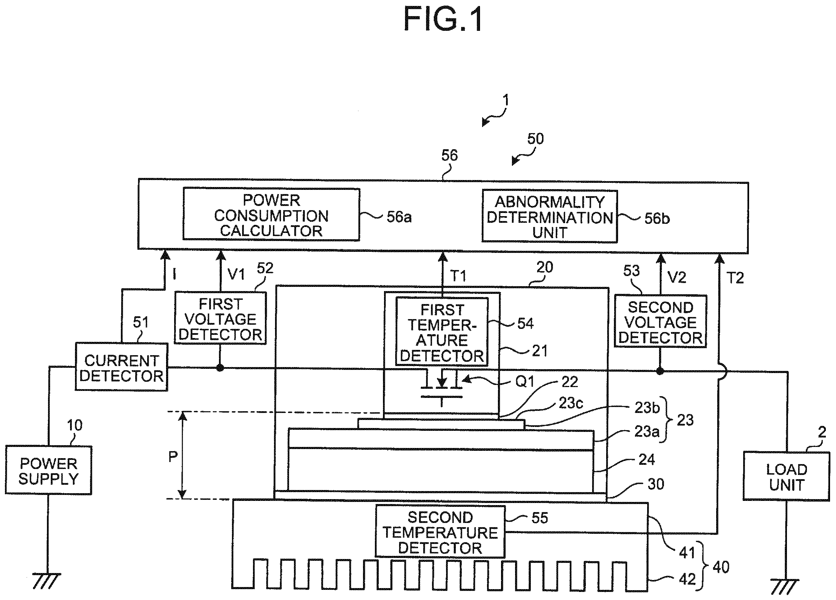

A power supply device 1 and an abnormality detection device 50 according to a first embodiment of the present invention will be described. The power supply device 1 is mounted, for example, on a vehicle, and serves to conduct or shut off a current flowing from a power supply 10 to a load unit 2 using a semiconductor switch 20. The power supply device 1 is configured by including the abnormality detection device 50. The abnormality detection device 50 serves to detect an abnormality in a heat dissipation path P of the semiconductor switch 20. The abnormality detection device 50 is not limited to being applied to the power supply device 1 mounted on the vehicle, but may be applied to other circuits. For example, as illustrated in FIG. 1, the power supply device 1 includes the power supply 10, the semiconductor switch 20, a heat dissipation joint portion 30, a heat sink 40 as a heat dissipation unit, and the abnormality detection device 50. The abnormality detection device 50 is configured by including a current detector 51, a first voltage detector 52, a second voltage detector 53, a first temperature detector 54, a second temperature detector 55, and a controller 56.

A stacking direction denotes a direction in which the semiconductor switch 20 and the heat sink 40 are stacked. An upper side in the stacking direction denotes the semiconductor switch 20 side in the stacking direction, and a lower side in the stacking direction denotes the heat sink 40 side in the stacking direction.

The power supply 10 serves to supply power. The power supply 10 is connected to the load unit 2 through, for example, the semiconductor switch 20, and supplies the power to the load unit 2.

The semiconductor switch 20 serves to conduct or shut off the current. The semiconductor switch 20 is provided between the power supply 10 and the load unit 2, and conducts or shuts off the current flowing between the power supply 10 and the load unit 2. The semiconductor switch 20 is configured by including a semiconductor chip 21, a die-bonding material 22, a substrate 23, and a heat dissipation plate 24. The semiconductor chip 21 is configured by including a field-effect transistor (FET) Q1 as a semiconductor device and the first temperature detector 54. The FET Q1 is, for example, an n-channel metal-oxide-semiconductor field-effect transistor (MOSFET), but is not limited thereto. The FET Q1 is mounted on a mounting surface 23c of the substrate 23. The FET Q1 is configured by including a drain terminal as an input terminal, a source terminal as an output terminal, and a gate terminal as a control terminal. The drain terminal is a terminal that receives the current. The drain terminal is connected to the positive electrode side of the power supply 10, and receives the current flowing from the power supply 10. The source terminal is a terminal that outputs the current received from the drain terminal. The source terminal is connected to the load unit 2 side, and outputs the current received from the drain terminal to the load unit 2. The gate terminal is a terminal that conducts or shuts off the current flowing from the drain terminal to the source terminal. The gate terminal is connected to a connection terminal of a drive circuit (not illustrated), and is put into an ON state or an OFF state based on a voltage applied from the drive circuit. When the gate terminal is in the ON state, the FET Q1 conducts the current from the drain terminal to the source terminal to energize the power supply device 1. When the gate terminal is in the OFF state, the FET Q1 stops conducting the current flowing from the drain terminal to the source terminal to shut off the power supply device 1. The FET Q1 generates heat when energized.

The first temperature detector 54 serves to detect the temperature of the FET Q1. The first temperature detector 54 is configured by including, for example, a temperature-sensitive diode or a thermistor. The first temperature detector 54 is provided to the FET Q1, and detects a junction temperature serving as the temperature of the FET Q1. The first temperature detector 54 is connected to the controller 56, and outputs a detection temperature T1 detected to the controller 56.

The die-bonding material 22 serves to bond the semiconductor chip 21 to the substrate 23. The die-bonding material 22 is made of, for example, an electrically conductive adhesive, solder, or silver (Ag) paste. The die-bonding material 22 bonds the semiconductor chip 21 to the substrate 23 in an electrically connected state.

The substrate 23 serves to support the semiconductor chip 21. The substrate 23 is formed in a plate shape, and has the mounting surface 23c on which the semiconductor chip 21 is mounted. The substrate 23 is configured by including an insulating plate 23a and a wiring layer 23b. The insulating plate 23a is a plate member having an insulating property. The wiring layer 23b is provided on an obverse surface of the insulating plate 23a located on the upper side thereof in the stacking direction. The heat dissipation plate 24 is provided on a reverse surface of the insulating plate 23a located on the lower side thereof in the stacking direction, that is, on a surface opposite to the obverse surface of the insulating plate 23a. The wiring layer 23b is a wiring pattern formed in a thin film shape on the obverse surface of the insulating plate 23a, and has an electrically conductive property. The wiring layer 23b is electrically connected to the semiconductor chip 21 through the die-bonding material 22.

The heat dissipation plate 24 serves to dissipate the heat. The heat dissipation plate 24 is a metal member formed in a plate shape, and is provided on the reverse surface of the insulating plate 23a. The heat of the FET Q1 of the semiconductor chip 21 is conducted to the heat dissipation plate 24 through the die-bonding material 22, the wiring layer 23b, and the insulating plate 23a. The heat dissipation plate 24 conducts the conducted heat of the FET Q1 to the heat sink 40 through the heat dissipation joint portion 30.

The heat dissipation joint portion 30 serves to join the semiconductor switch 20 to the heat sink 40. The heat dissipation joint portion 30 is made of a heat dissipation material (thermal interface material (TIM)) having an insulating property. The heat dissipation joint portion 30 joins the heat dissipation plate 24 side of the semiconductor switch 20 to the heat sink 40. The heat of the FET Q1 is conducted to the heat dissipation joint portion 30 through the heat dissipation plate 24. The heat dissipation joint portion 30 conducts the conducted heat of the FET Q1 to the heat sink 40.

The heat sink 40 serves to dissipate the heat generated in the FET Q1. The heat sink 40 is provided on a side of the semiconductor switch 20 opposite to the mounting surface 23c side of the substrate 23. The heat sink 40 is stacked on the substrate 23. The heat dissipation plate 24 serving as a heat conducting member capable of conducting heat and the heat dissipation joint portion 30 are interposed between the heat sink 40 and the substrate 23. The heat sink 40 is located in the outermost layer in the stacking direction in which the substrate 23 and the heat sink 40 are stacked, and is externally exposed. The heat sink 40 is configured by including a plate-like base portion 41 and a plurality of fin portions 42 provided in an erect manner on a side opposite to the substrate 23 side of the base portion 41. The base portion 41 is joined to the heat dissipation plate 24 of the semiconductor switch 20 with the heat dissipation joint portion 30 interposed therebetween. The base portion 41 conducts the heat of the FET Q1 conducted through the heat dissipation joint portion 30 to the fin portions 42. the fin portions 42 externally dissipate the heat of the FET Q1 conducted through the base portion 41.

The current detector 51 serves to detect a current. The current detector 51 is provided between the positive electrode of the power supply 10 and the drain terminal of the FET Q1, and detects the current (detection current I) flowing from the power supply 10 to the FET Q1. The current detector 51 is connected to the controller 56, and outputs the detected detection current I to the controller 56.

The first voltage detector 52 serves to detect a voltage. The first voltage detector 52 is connected between the positive electrode of the power supply 10 and the drain terminal of the FET Q1, and detects the voltage (first voltage V1) between the positive electrode of the power supply 10 and the drain terminal of the FET Q1. The first voltage detector 52 is connected to the controller 56, and outputs the detected first voltage V1 to the controller 56.

The second voltage detector 53 serves to detect a voltage. The second voltage detector 53 is connected between the source terminal of the FET Q1 and the load unit 2, and detects the voltage (second voltage V2) between the source terminal of the FET Q1 and the load unit 2. The second voltage detector 53 is connected to the controller 56, and outputs the detected second voltage V2 to the controller 56.

The second temperature detector 55 serves to detect a temperature of the heat sink 40. The second temperature detector 55 is configured by including, for example, a temperature-sensitive diode or a thermistor. The second temperature detector 55 is provided at the heat sink 40, and detects the temperature (detection temperature T2) of the heat sink 40. The second temperature detector 55 is connected to the controller 56, and outputs the detected detection temperature T2 of the heat sink 40 to the controller 56.

The controller 56 serves to control the FET Q1. The controller 56 is configured by including an electronic circuit mainly including a known microcomputer including a central processing unit (CPU), a read-only memory (ROM) and a random access memory (RAM) constituting a storage unit, and an interface. The controller 56 is configured by including the drive circuit (not illustrated), a power consumption calculator 56a, and an abnormality determination unit 56b. The drive circuit is connected to the gate terminal of the FET Q1. The drive circuit turns on the FET Q1 by applying the voltage to the gate terminal of the FET Q1, and turns off the FET Q1 by not applying the voltage to the gate terminal of the FET Q1.

The power consumption calculator 56a serves to obtain power consumption of the FET Q1. The power consumption calculator 56a is connected to the current detector 51, and acquires the detection current I detected by the current detector 51. The power consumption calculator 56a is also connected to the first voltage detector 52, and acquires the first voltage V1 detected by the first voltage detector 52. The power consumption calculator 56a is also connected to the second voltage detector 53, and acquires the second voltage V2 detected by the second voltage detector 53.

The power consumption calculator 56a obtains a voltage drop caused by the FET Q1 based on the first voltage V1 and the second voltage V2. The power consumption calculator 56a obtains the voltage drop (potential difference) caused by the FET Q1, for example, by subtracting the second voltage V2 from the first voltage V1. The power consumption calculator 56a obtains the power consumption of the FET Q1 based on the obtained potential difference (detection voltage) and the current (detection current I) flowing in the FET Q1. The power consumption calculator 56a obtains the power consumption of the FET Q1, for example, by calculating the product of the detection voltage and the detection current I. The power consumption calculator 56a is connected to the abnormality determination unit 56b, and outputs the power consumption of the FET Q1 to the abnormality determination unit 56b. The power consumption calculator 56a preferably obtains the power consumption based on, for example, the first and second voltages V1 and V2 averaged, for example, by filter processing using software, instead of obtaining the power consumption based on, for example, the first and second voltages V1 and V2 at a certain instant.

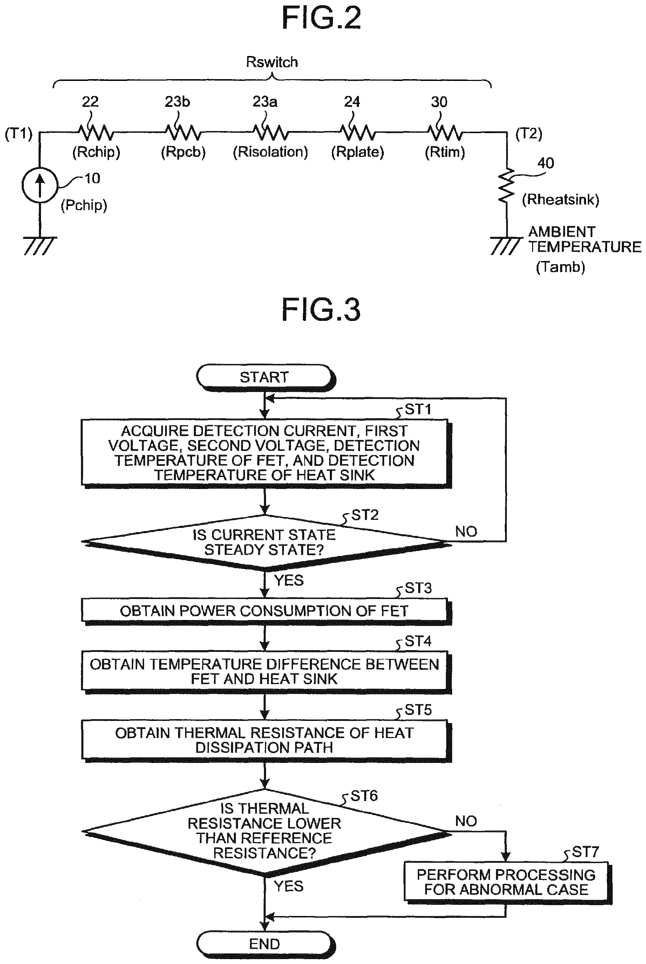

The abnormality determination unit 56b serves to determine the abnormality in the heat dissipation path P for the FET Q1. The abnormality determination unit 56b is connected to the power consumption calculator 56a, and acquires the power consumption of the FET Q1 from the power consumption calculator 56a. The abnormality determination unit 56b is also connected to the first temperature detector 54, and acquires the detection temperature T1 of the FET Q1 detected by the first temperature detector 54. The abnormality determination unit 56b is also connected to the second temperature detector 55, and acquires the detection temperature T2 of the heat sink 40 detected by the second temperature detector 55. The abnormality determination unit 56b determines the abnormality in the heat dissipation path P between the FET Q1 and the heat sink 40 based on a thermal resistance determined according to the detection temperature T1 of the FET Q1, the detection temperature T2 of the heat sink 40, and the power consumption of the FET Q1. The heat dissipation path P is a path constituted by components between the FET Q1 and the heat sink 40. The heat dissipation path P is the path constituted by, for example, the die-bonding material 22, the wiring layer 23b, the insulating plate 23a, the heat dissipation plate 24, and the heat dissipation joint portion 30. The heat dissipation path P can be represented as a thermal network in which each of the components between the FET Q1 and the heat sink 40 serves as a thermal resistance. For example, as illustrated in FIG. 2, the heat dissipation path P can be represented as the thermal network in which each of the die-bonding material 22, the wiring layer 23b, the insulating plate 23a, the heat dissipation plate 24, and the heat dissipation joint portion 30 serves as the thermal resistance, and the thermal resistances are connected in series. The thermal resistance represents difficulty for heat to flow.

The detection temperature T1 of the FET Q1 can be calculated by Expression (1) below. In Expression (1), Tamb denotes an ambient temperature; Pchip denotes the power consumption of the FET Q1; Rchip denotes the thermal resistance of the die-bonding material 22; Rpcb denotes the thermal resistance of the wiring layer 23b; Risolation denotes the thermal resistance of the insulating plate 23a; Rplate denotes the thermal resistance of the heat dissipation plate 24; Rtim denotes the thermal resistance of the heat dissipation joint portion 30; and Rheatsink denotes the thermal resistance of the heat sink 40.

$$\mathrm{T1 = Tamb + Pchip \times (Rchip + Rpcb + Risolation +}$$
$$\mathrm{Rplate + Rtim + Rheatsink)} \tag{1}$$

The detection temperature T2 of the heat sink 40 can be calculated by Expression (2) below. In Expression (2), Tamb denotes the ambient temperature; Pchip denotes the power consumption of the FET Q1; and Rheatsink denotes the thermal resistance of the heat sink 40.

$$\mathrm{T2 = Tamb + Pchip \times Rheatsink} \tag{2}$$

Expression (3) below can be derived based on Expressions (1) and (2).

$$\mathrm{\Delta T = (T1 - T2) = Pchip \times (Rchip + Rpcb + Risolation +}$$
$$\mathrm{Rplate + Rtim)} \tag{3}$$

In Expression (3), the expression (Rchip + Rpcb + Risolation + Rplate + Rtim) denotes the thermal resistance of the heat dissipation path P. Letting Rswitch denote the thermal resistance of the heat dissipation path P,

Expression (3) is expressed as Expression (4) below.

$$\Delta T = (T1 - T2) = Pchip \times Rswitch \qquad (4)$$

Dividing both sides of Expression (4) by Pchip, Expression (4) can be expressed as Expression (5) below.

$$Rswitch = \Delta T/Pchip = (T1 - T2)/Pchip \qquad (5)$$

The abnormality determination unit 56b can obtain the thermal resistance (Rswitch) of the heat dissipation path P based on Expression (5). In other words, the abnormality determination unit 56b can obtain the thermal resistance (Rswitch) of the heat dissipation path P by substituting the detection temperature T1 of the FET Q1, the detection temperature T2 of the heat sink 40, and the power consumption (Pchip) of the FET Q1 into Expression (5). The abnormality determination unit 56b determines the abnormality in the heat dissipation path P based on the thermal resistance (Rswitch) of the heat dissipation path P obtained by Expression (5).

In a transient state such as a state immediately after the power supply device 1 is started, that is, in a non-steady state, the abnormality determination unit 56b does not determine the abnormality in the heat dissipation path P. The non-steady state refers to a state in which a change per unit time in the detection temperature T1 of the FET Q1 is out of a predetermined range. In contrast, in a state after a certain length of time has passed since the power supply device 1 was started, that is, in a steady state, the abnormality determination unit 56b determines the abnormality in the heat dissipation path P. The steady state refers to a state in which the change per unit time in the detection temperature T1 of the FET Q1 is within the predetermined range. The abnormality determination unit 56b preferably performs, for example, the filter processing using software on the detection temperature T1 detected by the first temperature detector 54, and then determines whether the current state is the steady state or the non-steady state.

The abnormality determination unit 56b determines the abnormality in the heat dissipation path P based on the thermal resistance of the heat dissipation path P obtained by Expression (5) in the steady state. The thermal resistance of the heat dissipation path P tends to be relatively increased by, for example, a stress due to temperature or deterioration with time. The abnormality determination unit 56b compares the thermal resistance of the heat dissipation path P with a reference resistance set in advance, and determines that the abnormality has occurred in the heat dissipation path P if the thermal resistance of the heat dissipation path P is equal to or higher than the reference resistance. If the thermal resistance of the heat dissipation path P is lower than the reference resistance, the abnormality determination unit 56b determines that the abnormality has not occurred in the heat dissipation path P.

If the abnormality has occurred in the heat dissipation path P, the abnormality determination unit 56b performs processing for the abnormal case based on, for example, the use of the FET Q1 or required functional specifications as the vehicle. For example, if the abnormality has occurred in the heat dissipation path P, the abnormality determination unit 56b causes the drive circuit to turn off the FET Q1. The abnormality determination unit 56b notifies an upper-level electronic control unit (ECU) for controlling the entire vehicle of the abnormality in the heat dissipation path P for the FET Q1.

The following describes an operation example of the abnormality detection device 50 with reference to a flowchart illustrated in FIG. 3. The power consumption calculator 56a of the abnormality detection device 50 acquires the detection current I detected by the current detector 51, the first voltage V1 detected by the first voltage detector 52, and the second voltage V2 detected by the second voltage detector 53. The power consumption calculator 56a further acquires the detection temperature T1 of the FET Q1 detected by the first temperature detector 54 and the detection temperature T2 of the heat sink 40 detected by the second temperature detector 55 (Step ST1). The power consumption calculator 56a determines whether the current state is the steady state (Step ST2). The power consumption calculator 56a determines, for example, whether the change per unit time in the detection temperature T1 of the FET Q1 is within the predetermined range. If the current state is the steady state (Yes at Step ST2), the power consumption calculator 56a obtains the power consumption of the FET Q1 (Step ST3). The power consumption calculator 56a obtains the voltage drop (potential difference) caused by the FET Q1, for example, by subtracting the second voltage V2 from the first voltage V1. The power consumption calculator 56a obtains the power consumption of the FET Q1 based on the obtained voltage (potential difference) and the detection current I flowing into the FET Q1. The abnormality determination unit 56b then obtains a temperature difference between the FET Q1 and the heat sink 40 by subtracting the detection temperature T2 of the heat sink 40 from the detection temperature T1 of the FET Q1 (Step ST4).

Then, the abnormality determination unit 56b obtains the thermal resistance of the heat dissipation path P (Step ST5). The abnormality determination unit 56b obtains the thermal resistance of the heat dissipation path P, for example, by substituting the temperature difference ($\Delta T$) between the FET Q1 and the heat sink 40 and the power consumption (Pchip) of the FET Q1 into Expression (5). The abnormality determination unit 56b then determines whether the thermal resistance of the heat dissipation path is lower than the reference resistance (Step ST6). If the thermal resistance of the heat dissipation path is lower than the reference resistance (Yes at Step ST6), the abnormality determination unit 56b determines that the heat dissipation path P is normal, and ends the abnormality detection processing. If, in contrast, the thermal resistance of the heat dissipation path P is equal to or higher than the reference resistance (No at Step ST6), the abnormality determination unit 56b determines that the heat dissipation path P is abnormal, and performs the processing for the abnormal case (Step ST7). For example, the abnormality determination unit 56b causes the drive circuit to turn off the FET Q1, and notifies the upper-level ECU for controlling the entire vehicle of the abnormality in the heat dissipation path P for the FET Q1. If, at Step ST2 described above, the current state is the non-steady state (No at Step ST2), the power consumption calculator 56a returns the processing to Step ST1 to acquire the detection current I and so on again.

As described above, the abnormality detection device 50 according to the first embodiment includes the first temperature detector 54, the power consumption calculator 56a, the second temperature detector 55, and the abnormality determination unit 56b. The first temperature detector 54 detects the detection temperature T1 of the FET Q1 that is mounted on the mounting surface 23c of the substrate 23 and that generates heat when energized. The power consumption calculator 56a obtains the power consumption of the FET Q1. The second temperature detector 55 detects the detection temperature T2 of the heat sink 40 that is provided on the side opposite to the mounting surface 23c side of the substrate 23 and that dissipates the heat generated in the FET Q1. The controller 56 determines the abnormality in the heat dissipation path P between the FET Q1 and the heat sink 40 based on the thermal resistance determined according to the detection temperature T1 detected by the first temperature detector 54, the detection temperature T2 detected by the second temperature detector 55, and the power consumption obtained by the power consumption calculator 56a.

This configuration enables the abnormality detection device 50 to determine that the abnormality has occurred in the heat dissipation path P if, for example, the thermal resistance is equal to or higher than the reference resistance. By employing this determination method, the abnormality detection device 50 is made free from the need for, for example, detecting the temperature of the FET Q1 before being driven as is conventionally needed. Thus, the processing for detecting the abnormality need not be performed before driving the FET Q1. In other words, the abnormality detection device 50 can perform the processing for detecting the abnormality while the FET Q1 is in operation. This configuration allows the abnormality detection device 50 to more simply perform the processing for detecting the abnormality and to detect the abnormality in the heat dissipation path P in a shorter time than that conventionally required. As a result, the abnormality detection device 50 can appropriately detect the abnormality in the heat dissipation path P for the FET Q1, and can prevent the semiconductor switch 20 from malfunctioning.

In the abnormality detection device 50 described above, the controller 56 determines that the abnormality has occurred in the heat dissipation path P if the thermal resistance is equal to or higher than the reference resistance set in advance. This configuration enables the abnormality detection device 50 to appropriately detect the abnormality in the heat dissipation path P for the FET Q1.

In the abnormality detection device 50 described above, in the steady state in which the change per unit time in the temperature detected by the first temperature detector 54 is within the predetermined range, the controller 56 determines the abnormality in the heat dissipation path P. In contrast, in the non-steady state in which the change per unit time in the temperature detected by the first temperature detector 54 is out of the range, the controller 56 does not determine the abnormality in the heat dissipation path P. With this configuration, the abnormality detection device 50 does not determine the abnormality in the heat dissipation path P in the transient state such as the state immediately after the power supply device 1 is started. Therefore, the abnormality detection device 50 can appropriately determine the abnormality in the heat dissipation path P.

In the abnormality detection device 50 described above, the heat sink 40 is stacked on the substrate 23. The heat dissipation plate 24 serving as the heat conducting member capable of conducting the heat and the heat dissipation joint portion 30 are interposed between the heat sink 40 and the substrate 23. The heat sink 40 is located in the outermost layer in the stacking direction in which the substrate 23 and the heat sink 40 are stacked. This configuration enables the abnormality detection device 50 to detect the abnormality in the heat dissipation path P for the FET Q1 over a wide range from the FET Q1 to the outermost layer. In other words, the abnormality detection device 50 can detect the abnormality in the die-bonding material 22, the wiring layer 23b, the insulating plate 23a, the heat dissipation plate 24, and the heat dissipation joint portion 30.

The power supply device 1 according to the first embodiment includes the power supply 10, the FET Q1, the substrate 23, the heat sink 40, and the abnormality detection device 50. The power supply 10 supplies the power to the load unit 2. The FET Q1 conducts or shuts off the current flowing between the power supply 10 and the load unit 2, and generates the heat with the current. The substrate 23 is formed in the plate shape, and has the mounting surface 23c, on which the FET Q1 is mounted. The heat sink 40 is provided on the side opposite to the mounting surface 23c side of the substrate 23, and dissipates the heat generated in the FET Q1. The abnormality detection device 50 is configured by including the first temperature detector 54, the second temperature detector 55, the power consumption calculator 56a, and the abnormality determination unit 56b. The first temperature detector 54 detects the detection temperature T1 of the FET Q1. The second temperature detector 55 detects the detection temperature T2 of the heat sink 40. The power consumption calculator 56a detects the power consumption of the FET Q1. The abnormality determination unit 56b determines the abnormality in the heat dissipation path P between the FET Q1 and the heat sink 40 based on the thermal resistance determined according to the detection temperature T1 detected by the first temperature detector 54, the detection temperature T2 detected by the second temperature detector 55, and the power consumption detected by the power consumption calculator 56a. This configuration enables the power supply device 1 to provide the same effect as that of the abnormality detection device 50 described above.

Second Embodiment

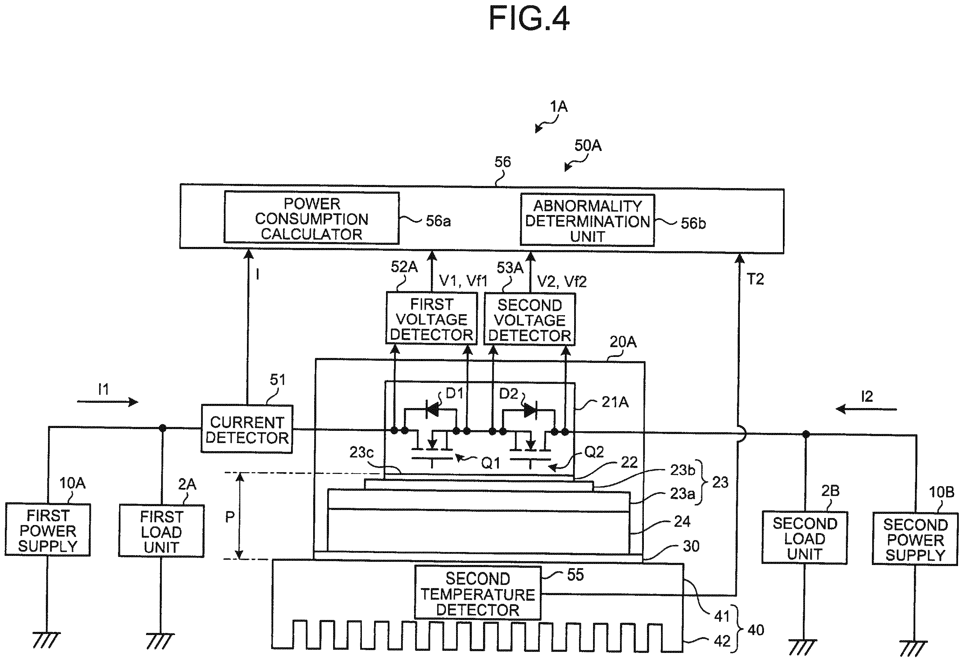

The following describes a power supply device 1A and an abnormality detection device 50A according to a second embodiment of the present invention. The same components of the second embodiment as those of the first embodiment are denoted by the same reference numerals, and the detailed description thereof will not be repeated. The power supply device 1A according to the second embodiment is a device that can conduct currents in both directions, and differs from the power supply device 1 according to the first embodiment by detecting a temperature based on temperature characteristics of forward voltages (also called a first forward voltage Vf1 and a second forward voltage Vf2) of diodes D1 and D2. The power supply device 1A is mounted, for example, on the vehicle, and conducts or shuts off the currents flowing in both directions. As illustrated in FIG. 4, the power supply device 1A includes a first power supply 10A, a second power supply 10B, a semiconductor switch 20A, the heat dissipation joint portion 30, the heat sink 40, and the abnormality detection device 50A. The power supply device 1A is what is called a two-battery device including the first power supply 10A and the second power supply 10B. The power supply device 1A supplies power to a first load unit 2A and a second load unit 2B connected in parallel with each other.

The first power supply 10A is connected in parallel with the first load unit 2A, and supplies the power to the first and second load units 2A and 2B. The second power supply 10B is connected in parallel with the second load unit 2B, and supplies the power to the first and second load units 2A and 2B. A current flowing from the first power supply 10A side toward the first and second load units 2A and 2B is called a positive directional current I1. A current flowing from the second power supply 10B side toward the first and second load units 2A and 2B is called a negative directional current 12.

The semiconductor switch 20A is configured by including a semiconductor chip 21A, the die-bonding material 22, the substrate 23, and the heat dissipation plate 24. The semiconductor chip 21A is configured by including the FET Q1 and an FET Q2. The FET Q1 and the FET Q2 are connected in opposite directions to each other. In other words, source terminals of the FET Q1 and the FET Q2 are connected to each other. The FET Q1 is, for example, an n-channel MOSFET, and includes the diode D1 (parasitic diode). The FET Q1 is mounted on the mounting surface 23c of the substrate 23. The FET Q1 is provided between the first power supply 10A and the second load unit 2B, and conducts or shuts off the current flowing from the first power supply 10A to the second load unit 2B. The FET Q1 is configured by including the drain terminal, the source terminal, and the gate terminal. The drain terminal is connected to the positive electrode side of the first power supply 10A. The source terminal is connected to the source terminal of the FET Q2. The gate terminal is connected to a connection terminal of the drive circuit (not illustrated). When the gate terminal is in the ON state, the FET Q1 conducts the current between the drain terminal and the source terminal. When the gate terminal is in the OFF state, the FET Q1 shuts off the current between the drain terminal and the source terminal. The FET Q1 conducts or shuts off the current flowing from the first power supply 10A to the second load unit 2B, and generates heat when energized.

The FET Q2 is, for example, an n-channel MOSFET, and includes the diode D2 (parasitic diode). The FET Q2 is mounted on the mounting surface 23c of the substrate 23. The FET Q2 is provided between the second power supply 10B and the first load unit 2A, and conducts or shuts off the current flowing from the second power supply 10B to first load unit 2A. The FET Q2 is configured by including a drain terminal, the source terminal, and a gate terminal. The drain terminal is connected to the positive electrode side of the second power supply 10B. The source terminal is connected to the source terminal of the FET Q1. The gate terminal is connected to a connection terminal of the drive circuit. When the gate terminal is in the ON state, the FET Q2 conducts the current between the drain terminal and the source terminal. When the gate terminal is in the OFF state, the FET Q2 shuts off the current between the drain terminal and the source terminal. The FET Q2 conducts or shuts off the current flowing from the second power supply 10B to the first load unit 2A, and generates heat when energized.

A first voltage detector 52A is connected to the drain terminal and the source terminal of the FET Q1, and detects a voltage (first voltage V1) between the drain terminal and the source terminal when the FET Q1 conducts the current. The first voltage detector 52A detects the forward voltage (first forward voltage Vf1) of the diode D1 when the FET Q1 is shut off. The forward voltage refers to a voltage when a forward current flows from the anode terminal to the cathode terminal of the diode D1. The first voltage detector 52A is connected to the controller 56, and outputs the first voltage V1 and the first forward voltage Vf1 that have been detected to the controller 56.

A second voltage detector 53A is connected to the drain terminal and the source terminal of the FET Q2, and detects a voltage (second voltage V2) between the drain terminal and the source terminal when the FET Q2 conducts the current. The second voltage detector 53A detects the forward voltage (second forward voltage Vf2) of the diode D2 when the FET Q2 is shut off. The second voltage detector 53A is connected to the controller 56, and outputs the second voltage V2 and the second forward voltage Vf2 that have been detected to the controller 56.

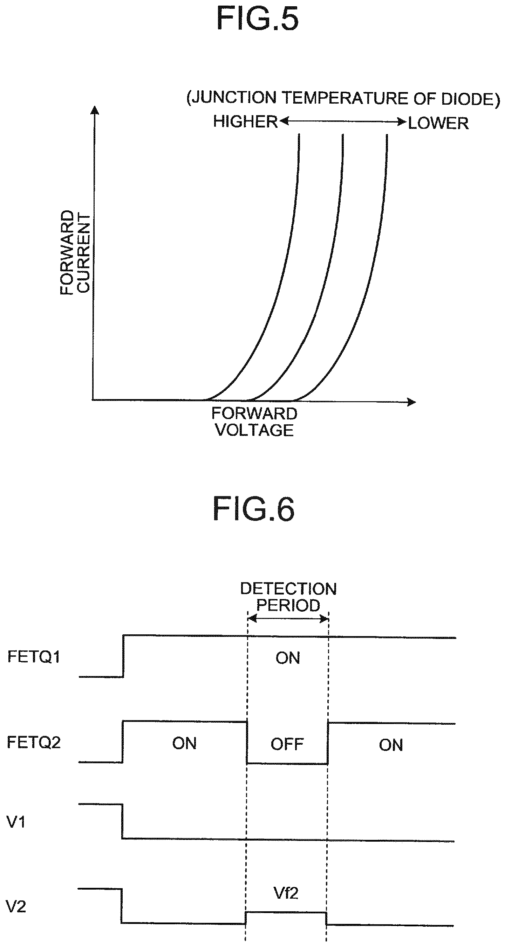

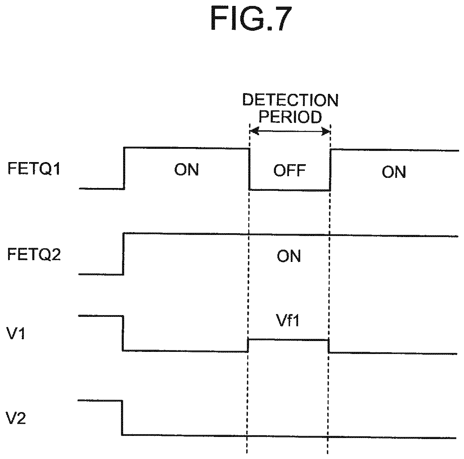

Each of the diodes D1 and D2 is known to have characteristics in which the forward voltage changes with temperature. These characteristics allow the controller 56 to estimate the junction temperature of the diodes D1 and D2 (FETs Q1 and Q2) based on forward currents of the diodes D1 and D2 and the forward voltages of the diodes D1 and D2, as illustrated in FIG. 5. If the positive directional current I1 is flowing, the controller 56 turns off the FET Q2 to detect the junction temperature of the FET Q2 during a predetermined detection period, as illustrated in FIG. 6. The second voltage detector 53A detects the second forward voltage Vf2 of the diode D2 of the FET Q2, and outputs the detected second forward voltage Vf2 of the diode D2 to the controller 56. If the negative directional current I2 is flowing, the controller 56 turns off the FET Q1 to detect the junction temperature of the FET Q1 during the predetermined detection period, as illustrated in FIG. 7. The first voltage detector 52A detects the first forward voltage Vf1 of the diode D1 of the FET Q1, and outputs the detected first forward voltage Vf1 of the diode D1 to the controller 56.

The controller 56 estimates the junction temperature of the FET Q1 based on the first forward voltage Vf1 of the diode D1 detected by the first voltage detector 52A and the detection current (forward current) I detected by the current detector 51 (refer to FIG. 5). The controller 56 estimates the junction temperature of the FET Q2 based on the second forward voltage Vf2 of the diode D2 detected by the second voltage detector 53A and the detection current (forward current) I detected by the current detector 51. The controller 56 may employ either one of the junction temperature of the FET Q1 and the junction temperature of the FET Q2 that have been estimated, or may employ the average value of the junction temperature of the FET Q1 and the junction temperature of the FET Q2 as a junction temperature of the FETs Q1 and Q2.

The power consumption calculator 56a is connected to the first voltage detector 52A, and acquires the first voltage V1 detected by the first voltage detector 52A. The power consumption calculator 56a is also connected to the second voltage detector 53A, and acquires the second voltage V2 detected by the second voltage detector 53A.

The power consumption calculator 56a obtains a voltage drop caused by the FETs Q1 and Q2 based on the first voltage V1 and the second voltage V2. The power consumption calculator 56a obtains the voltage drop (potential difference) caused by the FETs Q1 and Q2, for example, by summing the first voltage V1 and the second voltage V2.

The power consumption calculator 56a obtains the power consumption of the FETs Q1 and Q2 based on the obtained potential difference (voltage) and the current (detection current I) flowing to the FETs Q1 and Q2. The power consumption calculator 56a obtains the power consumption of the FETs Q1 and Q2, for example, by calculating the product of the obtained voltage and the detection current I.

The abnormality determination unit 56b determines the abnormality in the heat dissipation path P between the FETs Q1 and Q2 and the heat sink 40 based on the thermal resistance determined according to the junction temperature of the FETs Q1 and Q2, the detection temperature T2 of the heat sink 40, and the power consumption of the FETs Q1 and Q2.

As described above, the FETs Q1 and Q2 in the abnormality detection device 50A according to the second embodiment are configured by including the diodes D1 and D2. The forward voltages (the first forward voltage Vf1 and the second forward voltage Vf2) of the diodes D1 and D2 change with temperature. The controller 56 detects the temperature of the FETs Q1 and Q2 based on the forward voltages. This configuration allows the abnormality detection device 50A to dispense with the first temperature detector 54 that detects the temperature of the FET Q1 as is done in the abnormality detection device 50 of the first embodiment, and thus can restrain the semiconductor chip 21A from increasing in size.

Modification

The following describes a modification according to the first and second embodiments. Each of the FETs Q1 and Q2 is not limited to the n-channel MOSFET. For example, a p-channel MOSFET, an insulated gate bipolar transistor (IGBT), or a bipolar transistor may be used as each of the FETs Q1 and Q2.

The heat sink 40 has been described by way of the example configured by including the plate-like base portion 41 and the fin portions 42, but is not limited thereto. The heat sink 40 may have any shape that can effectively dissipate the heat of the FET Q1 (FET Q2).

The heat dissipation path P for the FET Q1 (FET Q2) has been described by way of the example constituted by the die-bonding material 22, the wiring layer 23b, the insulating plate 23a, the heat dissipation plate 24, and the heat dissipation joint portion 30, but is not limited thereto. The heat dissipation path P may be a path constituted by other elements.

The semiconductor switches 20 an 20A have been described by way of the examples each configured by including the heat dissipation plate 24, but are not limited thereto. For example, each of the semiconductor switches 20 an 20A need not include the heat dissipation plate 24.

The abnormality detection device and the power supply device according to the present embodiment determine the abnormality in the heat dissipation path between the semiconductor device and the heat dissipation unit based on the thermal resistance determined according to the detection temperature of the semiconductor device, the detection temperature of the heat dissipation unit, and the power consumption of the semiconductor device. With this configuration, the abnormality detection device and the power supply device need not perform, for example, the processing for detecting the abnormality before driving the semiconductor device, and therefore can appropriately detect the abnormality in the heat dissipation path for the semiconductor device.

Although the invention has been described with respect to specific embodiments for a complete and clear disclosure, the invention is defined by the appended claims.

**Claims**

1. An abnormality detection device (50) comprising:

    a first temperature detector (54) configured to detect a temperature of a semiconductor device (Q1) that is mounted on a mounting surface (23c) of a substrate (23) and that generates heat when energized;
    a second temperature detector (55) configured to detect a temperature of a heat dissipation unit (40) that is provided on a side opposite to the mounting surface (23c) side of the substrate (23) and that is configured to dissipate the heat generated in the semiconductor device (Q1);
    a power consumption calculator (56a) configured to obtain a power consumption of the semiconductor device (Q1) on the basis of a voltage drop across the semiconductor device (Q1) and a current flowing through the semiconductor device (Q1); and
    an abnormality determination unit (56b) configured to calculate a thermal resistance of a heat dissipation path (P) between the semiconductor device (Q1) and the heat dissipation unit (40) based on the temperature (T1) detected by the first temperature detector (54), the temperature (T2) detected by the second temperature detector (55), and the power consumption obtained by the power consumption calculator (56a), and to determine an abnormality in the heat dissipation path (P) based on the calculated thermal resistance.

2. The abnormality detection device (50) according to claim 1, wherein
    the abnormality determination unit (56b) is configured to determine that the abnormality has occurred in the heat dissipation path (P) when the calculated thermal resistance is equal to or higher than a reference resistance set in advance.

3. The abnormality detection device (50) according to claim 1 or 2, wherein

    in a steady state in which a change per unit time in the temperature (T1) detected by the first temperature detector (54) is within a predetermined range, the abnormality determination unit (56b) is configured to determine the abnormality in the heat dissipation path (P), and
    in a non-steady state in which the change per unit time in the temperature (T1) detected by the first temperature detector (54) is out of the range, the abnormality determination unit (56b) is configured not to determine the abnormality in the heat dissipation path (P).

4. The abnormality detection device (50) according to any one of claims 1 to 3, wherein

    the heat dissipation unit (40) is stacked on the substrate (23) with a heat conducting member (24, 30) interposed therebetween, the heat conducting member (24, 30) being capable of conducting heat, and
    the heat dissipation unit (40) is located in an outermost layer in a stacking direction in which the substrate (23) and the heat dissipation unit (40) are stacked.

5. The abnormality detection device (50) according to any one of claims 1 to 4, wherein

    the semiconductor device (Q1, Q2) includes a diode (D1, D2),
    a forward voltage (Vf1, Vf2) of the diode (D1, D2) changes with temperature, and
    the first temperature detector (54) is configured to detect the temperature of the semiconductor device (Q1, Q2) based on the forward voltage (Vf1, Vf2).

**6.** A power supply device (1) comprising:

a power supply (10) configured to supply power to a load (2) unit;

a semiconductor device (Q1) configured to conduct or shut off a current flowing between the power supply (10) and the load (2) unit, generating heat with the current;

a substrate (23) that is formed in a plate shape, and has a mounting surface (23c) on which the semiconductor device (Q1) is mounted;

a heat dissipation unit (40) that is provided on a side opposite to the mounting surface (23c) side of the substrate (23) and that is configured to dissipate the heat generated in the semiconductor device (Q1); and

an abnormality detection device (50) according to any of claims 1 to 5 for detecting an abnormality in a heat dissipation path (P) between the semiconductor device (Q1) and the heat dissipation unit (40).

**Patentansprüche**

**1.** Störungs-Erfassungsvorrichtung (50), die umfasst:

einen ersten Temperaturdetektor (54), der so ausgeführt ist, dass er eine Temperatur eines Halbleiterbauelementes (Q1) erfasst, das an einer Montagefläche (23c) eines Substrats (23) montiert ist und das bei Erregung Wärme erzeugt;

einen zweiten Temperaturdetektor (55), der so ausgeführt ist, dass er eine Temperatur einer Wärmeableitungs-Einheit (40) erfasst, die an einer der Seite der Montagefläche (23c) des Substrats (23) gegenüberliegenden Seite vorhanden ist und die so ausgeführt ist, dass sie die in dem Halbleiterbauelement (Q1) erzeugte Wärme ableitet;

eine Stromverbrauch-Berechnungseinrichtung (56a), die so ausgeführt ist, dass sie einen Stromverbrauch des Halbleiterbauelementes (Q1) auf Basis eines Spannungsgefälles über das Halbleiterbauelement (Q1) und eines durch das Halbleiterbauelement (Q1) fließenden Stroms ermittelt; sowie

eine Einheit (56b) für Feststellung von Störung, die so ausgeführt ist, dass sie einen Wärmewiderstand eines Wärmeableitungs-Weges (P) zwischen dem Halbleiterbauelement (Q1) und der Wärmeableitungs-Einheit (40) auf Basis der durch den ersten Temperaturdetektor (54) erfassten Temperatur (T1), der durch den zweiten Temperaturdetektor (55) erfassten Temperatur (T2) sowie dem durch die Stromverbrauch-Berechnungseinrichtung (56a) ermittelten Stromverbrauch berechnet und eine Störung auf dem Wärmeableitungs-Weg (P) auf Basis des berechneten Wärmewiderstandes feststellt.

**2.** Störungs-Erfassungsvorrichtung (50) nach Anspruch 1, wobei
die Einheit (56b) für Feststellung von Störung so ausgeführt ist, dass sie feststellt, dass die Störung auf dem Wärmeableitungs-Weg (P) aufgetreten ist, wenn der berechnete Wärmewiderstand genauso hoch ist wie oder höher als ein im Voraus festgelegter Bezugswiderstand.

**3.** Störungs-Erfassungsvorrichtung (50) nach Anspruch 1 oder 2, wobei

die Einheit (56b) für Feststellung von Störung so ausgeführt ist, dass sie in einem stabilen Zustand, in dem eine Änderung der durch den ersten Temperaturdetektor (54) erfassten Temperatur (T1) pro Zeiteinheit innerhalb eines vorgegebenen Bereiches liegt, die Störung auf dem Wärmeableitungs-Weg (P) feststellt, und

die Einheit (56b) für Feststellung von Störung so ausgeführt ist, dass sie in einem instabilen Zustand, in dem die Änderung der durch den ersten Temperaturdetektor (54) erfassten Temperatur (T1) pro Zeiteinheit außerhalb des Bereiches liegt, die Störung auf dem Wärmeableitungs-Weg (P) nicht feststellt.

**4.** Störungs-Erfassungsvorrichtung (50) nach einem der Ansprüche 1 bis 3, wobei

die Wärmeableitungs-Einheit (40) auf das Substrat (23) mit einem dazwischen angeordneten wärmeleitenden Element (24, 30) geschichtet ist, wobei das wärmeleitende Element (24, 30) in der Lage ist, Wärme zu leiten, und die Wärmeableitungs-Einheit (40) sich in einer äußersten Schicht in einer Schichtungsrichtung befindet, in der das Substrat (23) und die Wärmeableitungs-Einheit (40) geschichtet sind.

**5.** Störungs-Erfassungsvorrichtung nach einem der Ansprüche 1 bis 4, wobei

das Halbleiterbauelement (Q1, Q2) eine Diode (D1, D2) enthält,

eine Durchlassspannung (Vf1, Vf2) der Diode (D1, D2) sich mit einer Temperatur ändert und
der erste Temperaturdetektor (54) so ausgeführt ist, dass er die Temperatur des Halbleiterbauelementes (Q1, Q2) auf Basis der Durchlassspannung (Vf1, Vf2) erfasst.

6. Strom-Zufuhrvorrichtung (1), die umfasst:

eine Strom-Zufuhreinrichtung (10), die so ausgeführt ist, dass sie einer Last-Einheit (2) Strom zuführt;
ein Halbleiterbauelement (Q1), das so ausgeführt ist, dass es einen zwischen der Strom-Zufuhreinrichtung (10) und der Last-Einheit (2) fließenden Strom leitet oder sperrt und mit dem Strom Wärme erzeugt;
ein Substrat (23), das in einer Plattenform ausgebildet ist und eine Montagefläche (23c) aufweist, an der das Halbleiterbauelement (Q1) montiert ist;
eine Wärmeableitungs-Einheit (40), die an einer der Seite der Montagefläche (23c) des Substrats (23) gegenüberliegenden Seite vorhanden ist und die so ausgeführt ist, dass sie die in dem Halbleiterbauelement (Q1) erzeugte Wärme ableitet; sowie
eine Störungs-Erfassungsvorrichtung (50) nach einem der Ansprüche 1 bis 5 zum Erfassen einer Störung auf einem Wärmeableitungs-Weg (P) zwischen dem Halbleiterbauelement (Q1) und der Wärmeableitungs-Einheit (40).

**Revendications**

1. Dispositif de détection d'anomalie (50) comprenant :

un premier détecteur de température (54) configuré pour détecter une température d'un dispositif à semiconducteurs (Q1) qui est monté sur une surface de montage (23c) d'un substrat (23) et qui génère de la chaleur lorsqu'il est mis sous tension ;
un deuxième détecteur de température (55) configuré pour détecter une température d'une unité de dissipation de chaleur (40) qui est disposée sur un côté opposé au côté de surface de montage (23c) du substrat (23) et qui est configurée pour dissiper la chaleur générée dans le dispositif à semiconducteurs (Q1) ;
un calculateur de consommation électrique (56a) configuré pour obtenir une consommation électrique du dispositif à semiconducteurs (Q1) selon une chute de tension à travers le dispositif à semiconducteurs (Q1) et un courant s'écoulant à travers le dispositif à semiconducteurs (Q1) ; et
une unité de détermination d'anomalie (56b) configurée pour calculer une résistance thermique d'un trajet de dissipation de chaleur (P) entre le dispositif à semiconducteurs (Q1) et l'unité de dissipation de chaleur (40) selon la température (T1) détectée par le premier détecteur de température (54), la température (T2) détectée par le deuxième détecteur de température (55), et la consommation électrique obtenue par le calculateur de consommation électrique (56a), et pour déterminer une anomalie dans le trajet de dissipation de chaleur (P) selon la résistance thermique calculée.

2. Le dispositif de détection d'anomalie (50) selon la revendication 1, dans lequel
l'unité de détermination d'anomalie (56b) est configurée pour déterminer que l'anomalie s'est produite dans le trajet de dissipation de chaleur (P) lorsque la résistance thermique calculée est supérieure ou égale à une résistance de référence définie à l'avance.

3. Le dispositif de détection d'anomalie (50) selon la revendication 1 ou 2, dans lequel

dans un état constant dans lequel un changement par unité de durée dans la température (T1) détectée par le premier détecteur de température (54) s'inscrit dans une plage prédéterminée, l'unité de détermination d'anomalie (56b) est configurée pour déterminer l'anomalie dans le trajet de dissipation thermique (P), et
dans un état non constant dans lequel un changement par unité de durée dans la température (T1) détectée par le premier détecteur de température (54) s'inscrit hors de la plage, l'unité de détermination d'anomalie (56b) est configurée pour ne pas déterminer l'anomalie dans le trajet de dissipation thermique (P).

4. Le dispositif de détection d'anomalie (50) selon l'une quelconque des revendications 1 à 3, dans lequel

l'unité de dissipation de chaleur (40) est empilée sur le substrat (23) avec un élément thermoconducteur (24, 30) interposé entre ceux-ci, l'élément thermoconducteur (24, 30) étant en mesure de conduire de la chaleur, et l'unité de dissipation de chaleur (40) est positionnée dans une couche la plus à l'extérieur dans une direction d'empilement dans laquelle le substrat (23) et l'unité de dissipation de chaleur (40) sont empilés.

5. Le dispositif de détection d'anomalie (50) selon l'une quelconque des revendications 1 à 4, dans lequel

le dispositif à semiconducteurs (Q1, Q2) inclut une diode (D1, D2),
une tension directe (Vfl, Vf2) de la diode (D1, D2) change avec une température, et
le premier détecteur de température (54) est configuré pour détecter la température du dispositif à semiconducteurs (Q1, Q2) selon la tension directe (Vf1, Vf2) .

6. Dispositif d'alimentation (1) comprenant :

une alimentation (10) configurée pour fournir de l'électricité à une unité de charge (2) ;
un dispositif à semiconducteurs (Q1) configuré pour conduire ou arrêter un courant s'écoulant entre l'alimentation (10) et l'unité de charge (2), en générant de la chaleur avec le courant ;
un substrat (23) qui est constitué dans une forme de plaque, et présente une surface de montage (23c) sur laquelle le dispositif à semi-conducteurs (Q1) est monté ;
une unité de dissipation de chaleur (40) qui est disposée sur un côté opposé au côté de surface de montage (23c) du substrat (23) et qui est configurée pour dissiper la chaleur générée dans le dispositif à semiconducteurs (Q1) ; et
un dispositif de détection d'anomalie (50) selon l'une quelconque des revendications 1 à 5 pour détecter une anomalie dans un trajet de dissipation de chaleur (P) entre le dispositif à semiconducteurs (Q1) et l'unité de dissipation de chaleur (40).

# FIG.1

EP 3 561 530 B1

# FIG.2

Rswitch

# FIG.3

# FIG.4

# FIG.5

(JUNCTION TEMPERATURE OF DIODE)

HIGHER ← → LOWER

FORWARD
CURRENT

FORWARD
VOLTAGE

# FIG.6

DETECTION
PERIOD

FETQ1          ON

FETQ2    ON    OFF    ON

V1

V2          Vf2

# FIG.7

DETECTION
PERIOD

FETQ1    ON    OFF    ON

FETQ2    ON

V1    Vf1

V2

**EP 3 561 530 B1**

## REFERENCES CITED IN THE DESCRIPTION

### Patent documents cited in the description

- JP 2017017822 A
- JP 2014222802 A